# FASCICULE DE BREVET EUROPEEN

(11) **EP 1 695 145 B1**
(45) Date de publication et mention de la délivrance du brevet: **23.08.2017**
(21) Numéro de dépôt: 04816552.6
(22) Date de dépôt: 15.12.2004
(51) Int. Cl.: G03F 1/68

(54) **PROCÉDÉ DE RÉPARATION D' ERREURS DE MOTIFS RÉALISÉS DANS DES COUCHES MINCES**
VERFHAREN ZUR KORREKTUR VON FEHLERHAFTEN MOTIVEN IN DÜNNEN SCHICHTEN
METHOD FOR REPAIRING ERRORS OF PATTERNS EMBODIED IN THIN LAYERS

(30) Priorité: 16.12.2003 FR 0351067
(43) Date de publication de la demande: 30.08.2006
(73) Titulaire: Commissariat à l'Énergie Atomique et aux Énergies Alternatives, 75015 Paris (FR)
(72) Inventeur: PAIN, Laurent, F-38500 Saint Nicolas de Macherin (FR)
(74) Mandataire: Ahner, Philippe
(86) Numéro de dépôt international: PCT/FR2004/050698
(87) Numéro de publication internationale: WO 2005/059651

(56) Documents cités:
- GB-A- 1 412 995
- US-A- 5 945 238
- US-A- 5 953 577
- US-A- 5 985 518
- US-A1- 2002 122 995
- US-A1- 2003 027 053
- US-A1- 2003 039 923
- US-B1- 6 596 465
- PATENT ABSTRACTS OF JAPAN vol. 0093, no. 05 (E-363), 3 décembre 1985 (1985-12-03) & JP 60 142518 A (SUWA SEIKOSHA KK), 27 juillet 1985 (1985-07-27)

## Description

### DOMAINE TECHNIQUE

L'invention se rapporte au domaine des procédés de fabrication en couche minces par exemple de circuits intégrés électroniques ou de MEMS (MEMS pour microsystèmes électromécaniques) et plus particulièrement à celui de la réalisation de motifs sur des couches minces. L'invention peut par exemple s'appliquer à la réalisation de masques pour la lithographie tels que par exemple les masques pour la photolithographie à ultraviolet extrême. Elle propose une méthode permettant de réparer un dessin erroné réalisé dans une couche mince gravée.

### ETAT DE LA TECHNIQUE ANTERIEURE

La fabrication d'un circuit intégré en couches minces implique généralement la formation de motifs dans ces couches minces.

La réalisation d'un ou plusieurs motifs dans une couche mince fait appel le plus souvent à un procédé de photolithographie au cours duquel on emploie généralement un masque comportant un dessin reproduisant, généralement à une plus grande échelle, les motifs que l'on souhaite former dans la couche mince.

Toute erreur sur le dessin du masque, par exemple si un ou plusieurs motifs du masque sont en excédent ou manquants, peut se traduire directement par le non fonctionnement du circuit intégré. Cette erreur ou ces erreurs de dessin peut ou peuvent provenir du concepteur du dessin ou bien de défauts générés sur le masque lors de sa fabrication.

Dans le cas d'une erreur de conception du dessin du masque, il peut s'avérer nécessaire à la fois de produire un nouveau dessin puis de fabriquer un nouveau masque. Dans le cas de défauts de fabrication du masque, la fabrication d'un nouveau masque peut s'avérer nécessaire. Dans les deux cas, ces erreurs peuvent augmenter de manière importante le coût ainsi que les délais de fabrication du circuit intégré.

Il existe à ce jour des techniques permettant de réparer directement au niveau du masque des erreurs de dessin, telles que celles décrites dans les documents [1], [2], [3], référencés à la fin de la présente description. Le document US5953577 A décrit une méthode de gravure par photolithographie incluant une procédé de correction d'un dessin erroné. Les pertes en termes d'argent et de temps qu'impliquent des erreurs de dessin, faites sur un ou plusieurs lots de circuits intégrés en cours de fabrication, restent cependant importantes même lorqu'on effectue une réparation directement au niveau du masque.

En effet, les techniques consistant à effectuer une réparation au niveau du masque ne permettent généralement pas de réparer des lots erronés. D'autre part, pendant la réparation du masque d'autres lots en cours de fabrication et nécessitant l'emploi dudit masque peuvent se retrouver bloqués dans leur cycle fabrication.

### EXPOSÉ DE L'INVENTION

La présente invention concerne un procédé permettant de corriger des dessins erronés dans une couche mince réalisés, par exemple par photolithographie, à l'aide d'un masque comportant un défaut de fabrication ou/et un défaut de conception.

La couche mince peut être par exemple une couche d'un dispositif microélectronique en cours de réalisation, par exemple un MEMS en cours de réalisation (MEMS pour microsystèmes électromécaniques) ou un circuit intégré en cours de réalisation.

L'invention propose une solution simple, pour permettre de réduire des pertes de temps et des coûts induits par de telles erreurs de dessin faites sur des couches minces de dispositifs microélectroniques.

Contrairement aux techniques antérieures, l'invention permet par ailleurs de réutiliser des circuits intégrés en cours de fabrication comportant des erreurs de dessin.

L'invention concerne d'abord un procédé de correction d'un dessin formé dans une première couche mince, comprenant au moins une première sous couche gravée ou partiellement gravée comportant ledit dessin erroné, par exemple une sous-couche sacrificielle ou de masque dur, et au moins une deuxième sous-couche située entre le substrat et la première sous-couche, comportant les étapes de :
a) dépôt d'une seconde couche mince sur ladite première couche mince ou sur l'ensemble de la première couche mince,
b) lithographie à écriture directe de ladite seconde couche mince, en fonction de la correction ou des corrections souhaitée(s), puis:
   - gravure de la première sous-couche à travers la seconde couche mince, puis -retrait de la seconde couche mince, puis,
c) gravure de la deuxième sous-couche à travers la première sous-couche, puis
   - retrait de la première sous-couche.

On entend par dessin, un ensemble de motifs par exemple sous forme d'un ou plusieurs trous ou/et une ou plusieurs tranchées.

Dans la seconde couche mince, on forme donc, par lithographie, à l'aide d'un faisceau, ou de plusieurs faisceaux, un ou plusieurs éléments correctifs permettant la correction du dessin erroné.

Ensuite, on effectue la gravure de la deuxième sous-couche à travers la première sous-couche.

Une erreur de dessin dans la première couche mince peut être due à un ou plusieurs motifs manquants sur le dessin.

Dans ce cas, l'invention permet d'ajouter, un ou plusieurs motifs manquants. Cet ajout comporte la reproduction par l'étape b), des motifs manquants dans la seconde couche mince.

Selon une possibilité, à l'étape b) plusieurs éléments correctifs ou tous les correctifs peuvent être réalisés en même temps.

Par gravure on peut ensuite transférer, dans la première sous-couche, les motifs ajoutés dans la seconde couche mince.

La première sous-couche est gravée après l'étape b) et avant l'étape c), et la seconde couche mince est retirée après cette étape de gravure supplémentaire.

Ainsi, une fois que l'ajout de motifs a été réalisé dans la première sous-couche, celle-ci permet de reproduire les motifs dans la deuxième sous-couche, et la première sous-couche peut alors être retirée.

Une erreur de dessin dans la première couche mince peut être due à un ou plusieurs motifs en excédent sur le dessin. Dans ce cas, le procédé suivant l'invention permet la suppression d'un ou de plusieurs motifs en excédent, l'étape b) permettant de former des blocs de correction comblant ces motifs en excédent.

Selon une possibilité, à l'étape b) plusieurs blocs de correction ou tous les blocs de correction peuvent être réalisés en même temps.

Une erreur de dessin dans une couche mince peut être due à un ou plusieurs motifs manquants sur le dessin et à un ou plusieurs autres motifs en excédent sur le dessin. L'invention permet également d'ajouter un ou plusieurs motifs manquant(s), puis de supprimer un ou plusieurs motifs en excédent.

Le procédé selon l'invention peut alors comporter, après l'étape b) et avant l'étape c) :
- un retrait de la deuxième couche mince, un dépôt d'une troisième couche mince sur la première sous-couche, une seconde étape de gravure ou de lithographie dans la troisième couche mince laissant des blocs comblant les motifs en excédent,
- ou, alternativement, une gravure ou une lithographie, par exemple à écriture directe, à nouveau dans la seconde couche mince, et laissant des blocs comblant les motifs en excédent.

Dans l'un ou l'autre cas, on pourra, après l'étape c), retirer soit la troisième couche mince, soit la première sous-couche.

Les deux sous-couches constituant la première couche mince peuvent être réalisées à base de deux matériaux différents, chacun de ces deux matériaux pouvant être conducteur, semi-conducteur ou isolant.

La seconde et/ou la troisième couche mince peut être par exemple une couche diélectrique ou une couche de résine éventuellement photosensible et à tonalité positive ou négative que l'on dépose sur la première couche mince.

Les étapes de gravure peuvent être réalisées grâce à un ou plusieurs faisceau(x) optique(s) ou à un ou plusieurs faisceau(x) de particules. Le faisceau peut être de rayons x, ou un faisceau laser, ou un faisceau de protons, ou un faisceau d'ions, ou un faisceau d'électrons.

Selon une variante de mise en oeuvre, les étapes de gravure et notamment l'étape b) peuvent être réalisées grâce à plusieurs faisceaux optiques ou de particules simultanés.

Un tel faisceau ou de tels faisceaux peut ou peuvent être piloté(s) à l'aide d'un dispositif numérique dispositif ou de traitement numérique comportant des données de correction, préparées en fonction des corrections à effectuer.

Cette préparation peut être effectuée par comparaison entre des données de dessin ou un fichier de dessin erroné, et des données de dessin ou un fichier de dessin exact.

L'invention peut permettre de corriger ces dessins, sans nécessairement devoir utiliser de nouveau masque ni avoir besoin de corriger le masque défectueux. Un dispositif de lithographie apte à effectuer l'étape b) du procédé suivant l'invention peut comprendre :
- un appareil de lithographie ou des premiers moyens apte(s) à produire au moins un faisceau de lithographie,
- des seconds moyens pour traiter des données relatives au dessin erroné et à un dessin corrigé souhaité, et pour produire suite à ce traitement, des données de correction,
- des troisièmes moyens pour piloter l'appareil de lithographie, à partir des données de correction.

L'invention utilise un programme d'ordinateur comprenant des instructions de code de programme enregistrable dans cet ordinateur pour traiter des données relatives à un dessin erroné réalisé dans une couche mince et des données relatives à un dessin corrigé souhaité, et pour produire suite à ce traitement, des données de correction exploitables par un appareil de lithographie ou par des moyens apte(s) à produire au moins un faisceau optiques ou de particules pour la lithographie.

L'invention utilise également un produit programme d'ordinateur comprenant des instructions de code d'un tel programme enregistré sur un support utilisable dans un ordinateur, ainsi qu'un support de données numériques utilisables par un ordinateur, comprenant des instructions de code d'un tel programme.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
- les figures 1A-1B représentent une couche de matériau dans laquelle on souhaite réaliser des motifs,
- les figures 2, 4, 6 et 8 représentent une couche de matériau dans laquelle un motif en excédant ou manquant est réalisé,
- les figures 3A-3F, illustrent un exemple de procédé suivant l'invention permettant la correction par ajouts de motifs,
- les figures 5A-5B, illustrent un autre exemple de procédé suivant l'invention permettant la correction par ajouts de motifs,
- les figures 7A-7C, illustrent un exemple de procédé suivant l'invention permettant la correction par suppressions de motifs,
- les figures 9A-9D, illustrent un exemple de procédé suivant l'invention permettant la correction par ajouts puis suppressions de motifs.
- la figure 10, illustre un exemple de dispositif suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

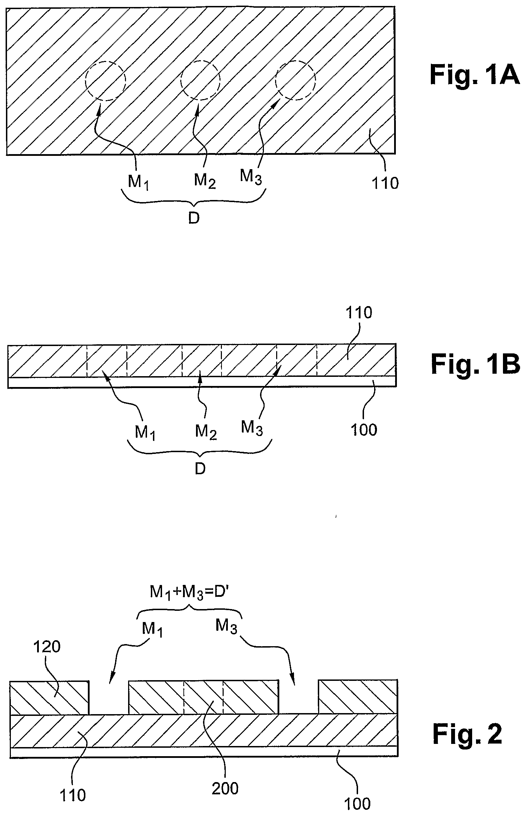

La figure 1A illustre une couche mince vue de dessus dans laquelle on souhaite réaliser des motifs notés M₁, M₂, M₃, sous forme de motifs en creux (dont les contours sont représentés en traits discontinus sur cette figure), par exemple de trous d'interconnexion, ou de tranchées susceptibles d'être remplies par la suite, par un matériau semi-conducteur, ou conducteur ou diélectrique. Cette couche mince sera nommée couche technologique et notée 110. Elle repose sur un substrat, par exemple un substrat en silicium (non représenté sur la figure 1A). L'ensemble des motifs M₁, M₂, M₃, formera un dessin D.

La couche technologique 110 peut être de nature organique ou minérale, elle peut être conductrice ou semi-conductrice ou isolante et peut avoir une épaisseur comprise par exemple entre 1 nanomètre et 10 micromètres.

Cette couche mince 110 peut être une couche d'un dispositif microélectronique, par exemple un circuit intégré, en cours de réalisation.

La couche technologique 110 illustrée sur la figure 1A, est par exemple une couche à base de TeOS de 600 nanomètres d'épaisseur.

La figure 1B illustre une vue en coupe de cette même couche technologique 110 reposant sur le substrat 100. Les motifs M₁, M₂, M₃, que l'on souhaite réaliser sous forme de motifs en creux dans la couche technologique 110 sont également délimités par des contours en traits discontinus.

Pour réaliser les motifs M₁, M₂, M₃, dans la couche technologique 110, une première méthode consiste par exemple à former tout d'abord ces motifs M₁, M₂, M₃, par photolithographie dans une couche que l'on appellera couche sacrificielle, déposée préalablement sur la couche technologique. Ensuite, il s'agit de transférer les motifs M₁, M₂, M₃, dans la couche technologique 110 par exemple par gravure de cette dernière à travers la couche sacrificielle.

La figure 2 illustre la couche technologique 110 reposant sur le substrat 100 et recouverte en outre par une couche sacrificielle 120 ajourée dans laquelle on a voulu former lesdits motifs M₁, M₂, M₃, par un procédé de photolithographie faisant appel à un masque.

La couche sacrificielle peut être de nature organique ou minérale, elle peut être conductrice ou semi-conductrice ou isolante et peut avoir une épaisseur comprise par exemple entre 1 nanomètre et 10 micromètres. La couche sacrificielle 120 illustrée sur la figure 2 est par exemple une couche à base de TiN de 50 nanomètres d'épaisseur.

Suite audit procédé de photolithographie, la couche sacrificielle 120 illustrée sur la figure 2 est gravée selon un dessin erroné noté D' différent du dessin D que l'on souhaitait réaliser et auquel manque le motif M₂. Le dessin erroné D' peut provenir d'un masque, utilisé lors du procédé de photolithographie et qui comportait lui-même des défauts.

Ainsi, le motif M₂ manque dans la couche sacrificielle 120, à un emplacement 200 (délimité par des traits discontinus sur la figure 2).

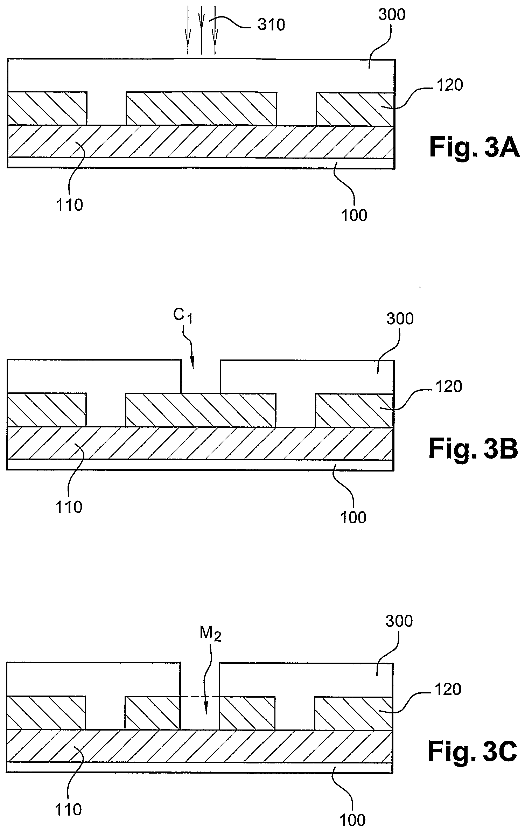

Un premier exemple de procédé suivant l'invention est illustré aux figures 3A-3F. Il permet de corriger le dessin erroné D' auquel manque un motif.

Lors d'une première étape de ce procédé illustrée sur la figure 3A, on dépose, sur la couche sacrificielle 120 ou sur l'ensemble de la couche sacrificielle 120, une couche 300 par exemple à base de résine ou de polymère. Cette couche 300 peut être sensible à un rayonnement par exemple électronique, ionique ou photonique. La couche 300 peut être par exemple une couche de résine, par exemple à tonalité positive telle qu'une résine TiS193UL ^{®} de la société Archechemical, ou une résine NOVOLAC ^{®}, ou une résine PHS ^{®}. Selon une variante, la couche 300 peut également formée d'un empilement de plusieurs sous-couches, par exemple d'une première sous-couche à base de résine non photosensible surmontée d'une deuxième sous-couche sensible à un rayonnement par exemple électronique, ionique ou photonique.

Ensuite, on effectue une étape de lithographie de cette couche 300, en fonction du dessin erroné D'. Cette étape de lithographie permet de former un élément correctif C₁ dans la couche 300. L'élément correctif C₁ sera réalisé dans la couche 300, après révélation, et prendra dans ce cas, une forme identique au motif M₂ manquant dans la couche sacrificielle 120.

Selon une possibilité de mise en oeuvre du procédé, la lithographie de la couche 300, peut être réalisée par lithographie à écriture directe, sans avoir à utiliser de masque intermédiaire. Ainsi, le procédé peut permettre d'ajouter le motif manquant dans la couche sacrificielle sans nécessairement devoir employer un nouveau masque.

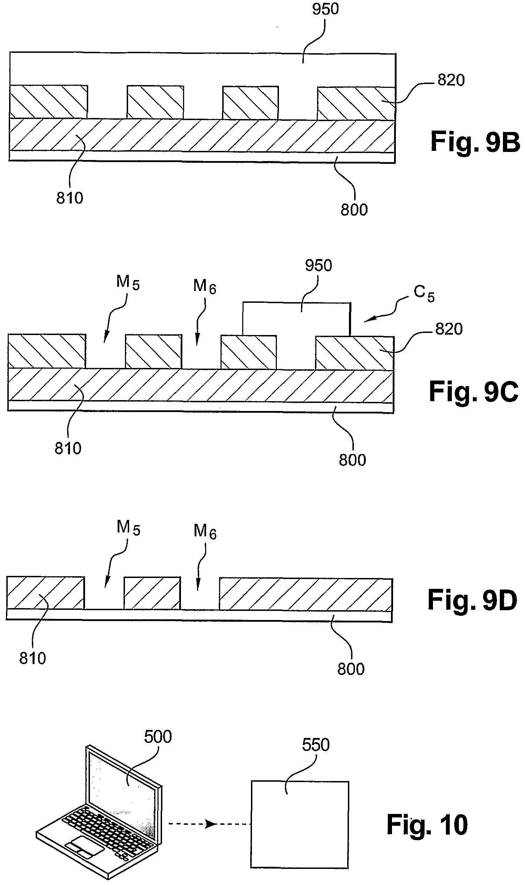

L'élément correctif C₁ peut être formé et placé sur la couche de résine 300, en fonction à la fois du dessin erroné D' dans la couche sacrificielle 120 et du dessin D original. En effet, la lithographie peut être réalisée par exemple par un dispositif de lithographie ou de photolithographie (figure 10), dans lequel un appareil de lithographie ou de photolithographie 550 utilise un fichier informatique lui indiquant des informations concernant la forme ainsi que l'emplacement de l'élément correctif à réaliser. Le fichier peut être issu, par exemple, d'une base de données ou d'un support de données provenant d'un dispositif de traitement informatique 500 tel qu'un ordinateur ou une station de travail et peut résulter d'un traitement, effectué par cet ordinateur ou cette station de travail, dans lequel une comparaison entre le dessin D original et le dessin erroné D' est effectué.

La lithographie peut être réalisée grâce à au moins un faisceau 310, de particules ou optique, au moyen duquel on expose certaines parties de la couche de résine 300 pour réaliser l'élément correctif C₁.

Le faisceau 310 peut être par exemple un faisceau laser, ou un faisceau de rayons X, ou un faisceau d'électrons, ou un faisceau d'ions, ou un faisceau de protons.

Après exposition au faisceau 310 de la couche de résine 300, on développe cette dernière. Les parties de la couche de résine 300 exposées au faisceau 310 sont révélées et disparaissent pour former l'élément correctif C₁ qui a une forme identique au motif M₂ manquant dans la sous-couche sacrificielle 120 (figure 3B). La gravure directe définit des zones surmontées de parties de la couche 300 et d'autres zones ne comportant pas de parties de la couche 300.

Puis (figure 3C), on effectue le transfert de l'élément correctif C₁ dans la couche sacrificielle 120. Le transfert peut être effectué par gravure chimique ou par bombardement de particules, par exemple une gravure plasma ou une gravure chimique par voie humide de la couche sacrificielle 120 à travers la couche de résine 300. La couche sacrificielle 120 comporte alors le motif C₁. Ce motif correspond au motif M₂ que l'on souhaitait ajouter dans la couche sacrificielle.

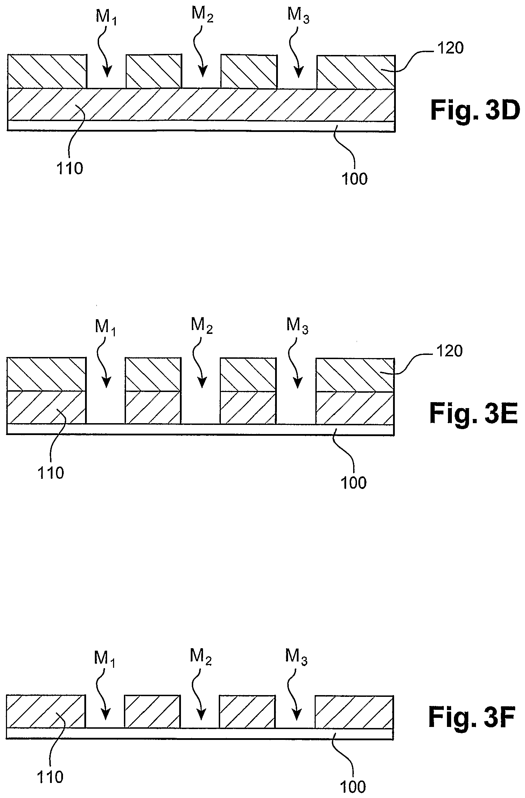

Ensuite, on retire la couche de résine 300. La couche sacrificielle comprend alors les motifs M₁, M₂, M₃, et par conséquent le dessin D (figure 3D) .

Puis, par gravure, par exemple par gravure chimique ou plasma de la couche technologique 110 à travers la couche sacrificielle 120, on transfère les motifs M₁, M₂, M₃, dans la couche technologique 110 (figure 3E).

On retire enfin la couche sacrificielle 120 (figure 3F). Le retrait de la couche sacrificielle 120 peut être effectué par gravure sèche, par exemple à l'aide d'un plasma à base d'un gaz réactif à cette couche 120. Il peut être effectué également effectué par gravure humide par exemple à l'aide d'une solution à base de H₂O₂ et de H₂SO₄ dans le cas où la couche sacrificielle 120 est de nature organique. Eventuellement, le retrait peut également, être effectué par une combinaison d'une gravure chimique humide suivie d'une gravure plasma.
Le procédé suivant l'invention n'est pas limité à la correction ou à l'ajout d'un seul motif : Il permet d'ajouter autant de motifs que nécessaire à une couche mince gravée selon un dessin erroné, par exemple suite à un procédé de photolithographie.

Le procédé ci-dessus s'applique au cas où une couche sacrificielle est utilisée au dessus de la couche technologique.

Mais, pour réaliser des motifs tels que les motifs M₁, M₂, M₃, illustrés sur la figure 1A et 1B dans une couche mince telle que la couche technologique 110, une méthode consiste à former ces motifs M₁, M₂, M₃, par photolithographie, directement dans cette couche technologique 110 et sans utiliser de couche sacrificielle intermédiaire.

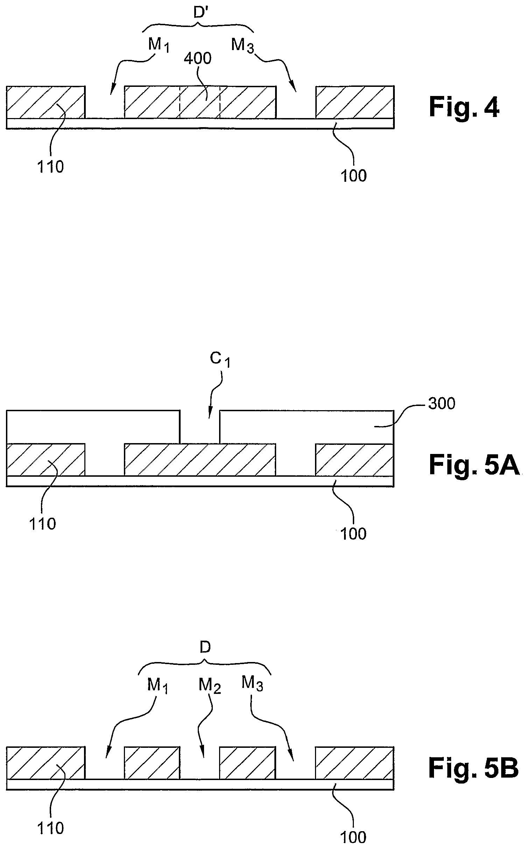

La figure 4 illustre cette couche technologique 110 ajourée, par exemple par photolithographie, ayant nécessitée l'emploi d'un masque, et grâce à laquelle on a voulu former lesdits motifs M₁, M₂, M₃.

Une erreur, par exemple, de conception ou de fabrication du masque utilisé lors du procédé de photolithographie a entraîné la formation d'un dessin erroné D' directement dans la couche technologique 110, différent du dessin D que l'on souhaitait réaliser.

Ainsi, le motif M₂ est manquant dans la couche technologique 110, l'emplacement de ce motif M₂ manquant étant indiqué par des hachures et par la référence 400 sur la figure 4.

Un second exemple de procédé ne faisant pas partie de l'invention est illustré sur les figures 5A-5B, et permet de corriger le dessin erroné D', réalisé dans la couche technologique et auquel manque un motif.

Cet exemple de procédé permet ainsi d'ajouter le motif manquant dans la couche technologique sans employer de nouveau masque.

Lors d'une première étape de ce procédé, on dépose une couche de résine 300 par exemple une couche de résine photosensible à tonalité positive sur la couche technologique 110.

Ensuite, on effectue une lithographie de la couche de résine 300. Cette lithographie peut être par exemple de type dit « à écriture directe », c'est-à-dire sans utiliser de masque intermédiaire. La lithographie est réalisée en fonction du dessin erroné D' dans la couche technologique 110 et du dessin D souhaité dans cette même couche. Elle permet de réaliser au moins un élément correctif C₁ dans la couche de résine 300. Dans cet exemple, l'élément correctif est identique au motif M₂ manquant sur le dessin D'.

La lithographie peut être effectuée par au un faisceau ou au moins un faisceau, de particules ou optique, au moyen duquel on expose certaines parties de la couche de résine 300 pour former l'élément correctif C₁. Le faisceau peut être par exemple un faisceau laser, ou un faisceau de rayons X, ou un faisceau d'électrons ou un faisceau d'ions ou encore un faisceau de protons.

Après exposition de la couche de résine 300, on développe cette dernière. Les parties de la couche de résine 300 exposées au faisceau disparaissent pour produire, dans la couche technologique 110, l'élément ou motif correctif C₁ ayant une forme identique au motif M₂ (figure 5A) .

Ensuite, on transfère l'élément correctif C₁ dans la couche technologique 110 en effectuant une gravure, par exemple une gravure plasma ou une gravure chimique de cette dernière à travers la couche de résine 300. La couche technologique 110 comporte alors un motif en creux, qui correspond au motif M₂ manquant que l'on souhaitait ajouter.

On retire ensuite la couche de résine 300. La couche technologique 110 comprend alors les motifs M₁, M₂, et M₃ formant le dessin D complet (figure 5B).

Le procédé suivant l'invention n'est pas limité à la correction d'un seul motif dans une couche mince comme dans l'exemple précédemment décrit. Il permet en effet d'ajouter autant de motifs que nécessaire dans une couche mince gravée et à laquelle manquent certains motifs.

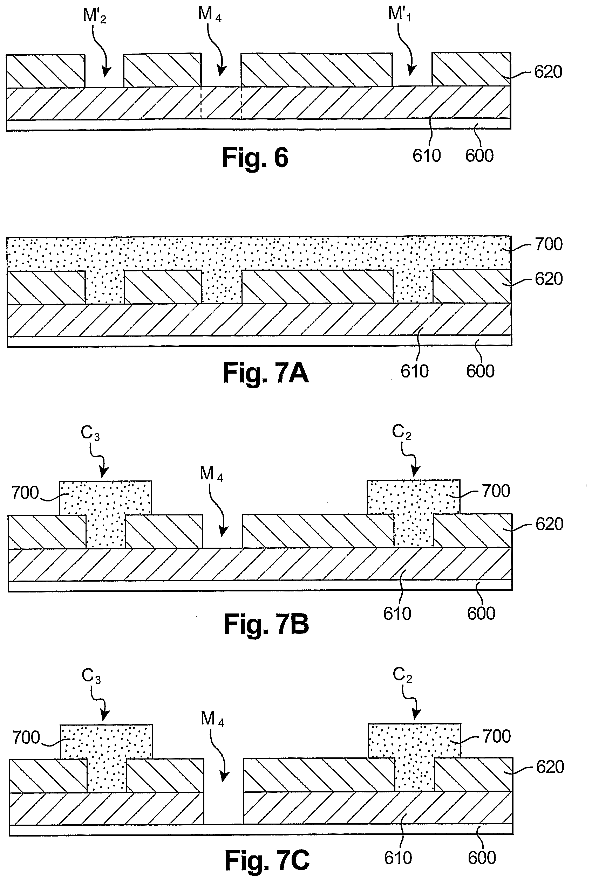

La figure 6 illustre un substrat 600, par exemple en silicium et recouvert par une couche mince 610 que l'on nommera couche technologique dans laquelle on souhaite réaliser un motif M₄ par exemple sous forme d'un creux, par exemple une tranchée illustrée par des contours en pointillés. La couche technologique 610 peut être de nature organique ou minérale, elle peut être conductrice ou semi-conductrice ou isolante. C'est par exemple une couche métallique à base de TiN ou par encore une couche diélectrique de faible constante diélectrique, ou encore une couche de polysilicium servant à la réalisation des grilles de transistors.

Pour réaliser le motif M₄ dans la couche technologique 610, une première méthode peut consister à former tout d'abord ce motif M₄ par photolithographie d'une couche 620, que l'on appellera couche sacrificielle, déposée sur la couche technologique 610.

Suite à une erreur, par exemple de conception ou de fabrication d'un masque utilisé lors dudit procédé de photolithographie, la couche sacrificielle 620 illustrée sur la figure 6 comporte le motif M₄ mais aussi plusieurs motif erroné M'₁, M'₂ en excédent, sous forme de trou(s) ou/et de tranchée(s).

L'exemple de procédé suivant l'invention illustré sur les figures 7A-7C, permet de corriger ces motifs M'₁ et M'₂ réalisés en excédent et de former uniquement le bon motif dans la couche technologique.

Lors d'une première étape, on dépose une couche de résine 700 sur l'ensemble de la couche sacrificielle 620 (figure 7A).

Ensuite, on effectue une étape de lithographie de la couche de résine 700. Selon une mode de réalisation du procédé, cette lithographie peut être à écriture directe, c'est-à-dire sans utiliser de masque intermédiaire.

La lithographie est réalisée en fonction du dessin erroné D' formé dans la couche sacrificielle 620. L'étape de lithographie permet de réaliser des éléments correctifs C₂ et C₃ dans la couche de résine 700. Ces éléments correctifs C₂ et C₃ prennent, dans ce cas, la forme de blocs de résine venant combler respectivement les motifs erroné M'₁ et M'₂ sous forme de trou ou de tranchée dans la couche sacrificielle 620.

La lithographie peut être réalisée grâce à un faisceau ou plusieurs faisceaux, éventuellement de plusieurs faisceaux simultanés, de particules ou optique(s), au moyen duquel ou desquels on expose certaines parties de la couche de résine 700 pour réaliser les éléments correctifs C₂ et C₃.

Le ou les faisceaux peuvent être par exemple à base de rayons X ou d'électrons, ou de rayons UV.

Après exposition de la couche de résine 700, par le ou les faisceau(x) on développe cette dernière. Les parties de la couche de résine 700 exposées au faisceau 310 disparaissent. Il reste alors les éléments correctifs C₂ et C₃, qui prennent la forme de blocs de résine, et qui viennent combler respectivement les motif M'₁ et M'₂ en excédent dans la sous-couche sacrificielle 620 (figure 7B).

On effectue ensuite (figure 7C) le transfert uniquement du motif M₄ exact, par exemple par gravure, par exemple encore une gravure plasma ou une gravure chimique de la couche technologique 610 à travers la couche de sacrificielle 620. Les motifs erronés M'₁ et M'₂ de la couche sacrificielle 620 étant comblés par les blocs de résine 700, seul le motif M₄ est transféré dans la couche technologique 610. On retire ensuite la couche sacrificielle.

Le procédé suivant l'invention n'est pas limité à la correction de deux motifs comme dans l'exemple précédemment décrit : il permet en effet de supprimer autant de motifs en excédent que nécessaire.

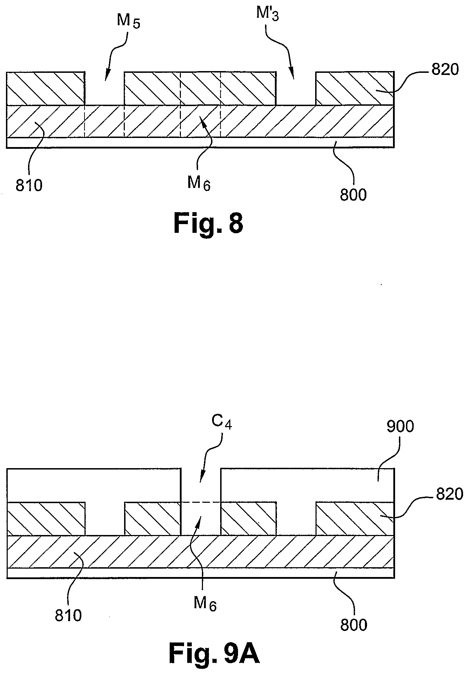

La figure 8 illustre un substrat 800, par exemple en silicium, recouvert par une couche mince notée 810, que l'on nommera couche technologique et, dans laquelle on souhaite réaliser des motifs M₅ et M₆ qui prendront par exemple la forme de trous ou de tranchées et qui sont illustrés sur la figure 8 par des contours en traits discontinus.

La couche technologique peut être conductrice ou semi-conductrice ou isolante et avoir une épaisseur comprise par exemple entre 1 nanomètre et 10 micromètres. La couche technologique 810 est par exemple une couche diélectrique de constante diélectrique faible (« low-k » selon la terminologie anglo-saxonne »).

Pour réaliser les motif M₅ et M₆ dans cette couche technologique 810, une méthode consiste à former tout d'abord ces motifs M₅ et M₆ par un procédé de photolithographie d'une autre couche mince notée 820, que l'on appellera couche sacrificielle, et qui est déposée sur la couche technologique 810. La couche sacrificielle 820 est par exemple une couche à base de nitrure ou d'oxyde de silicium.

Suite à une erreur, par exemple de conception ou de fabrication d'un masque utilisé lors dudit procédé de photolithographie, la couche sacrificielle 820 illustrée sur la figure 8 est gravée selon un dessin erroné comportant le motif M₅ exact, mais auquel manque le motif M₆. Ce dessin erroné comporte en outre un motif erroné M'₃ en excédent dans la couche sacrificielle 820 et qui prend par exemple la forme d'un trou ou d'une tranchée.

Un exemple de procédé suivant l'invention permettant de corriger un tel dessin réalisé dans une couche mince gravée telle que la couche sacrificielle 820, dans lequel certains motifs sont en excédent et auquel certains motifs manquent va à présent être décrit. Il est illustré par les figures 9A-9C.

Lors d'une première étape de ce procédé, on dépose une première couche de résine 900 sur la couche sacrificielle 820. La couche de résine 900 peut être par exemple une résine photosensible à tonalité positive

Ensuite, on effectue une première étape de lithographie ou de photolithographie. Selon une possibilité, cette lithographie peut être à écriture directe de la couche de résine 900, c'est-à-dire sans utiliser de masque intermédiaire. Cette première étape de lithographie permet de former un premier élément correctif noté C₄ dans la couche de résine 900 sous forme d'une lumière identique au motif M₆ manquant.

La lithographie peut être réalisée grâce à un faisceau de particules ou un faisceau optique au moyen duquel on expose certaines parties de la couche de résine 900 pour former l'élément correctif C₄. Ledit faisceau peut être par exemple un faisceau de rayons X, un faisceau laser, un faisceau d'électrons, un faisceau d'ions, un faisceau de protons, ou un faisceau de rayons UV. Après exposition par le faisceau de la couche de résine 900, on développe cette dernière. Les parties de la couche de résine 900 exposées au faisceau disparaissent pour former l'élément correctif C₄.

Ensuite, on effectue une gravure de la couche sacrificielle 820 à travers la couche de résine 900. La gravure permet de transférer, dans la couche sacrificielle, l'élément correctif C₄. La couche sacrificielle 820 comporte alors le motif M₆ manquant sous forme de tranchée ou d'un trou (figure 9A).

Ensuite, on retire la première couche de résine 900 puis on dépose une seconde couche de résine 950 par exemple une couche de résine photosensible à tonalité négative.

Ensuite, on effectue une seconde étape de lithographie à écriture directe de la seconde couche de résine 950, sans utiliser de masque intermédiaire (figure 9C). Cette seconde étape de lithographie à écriture directe permet de préparer la formation d'un second élément correctif dans la couche de résine 950 sous forme d'un bloc de résine C₅ venant combler le motif M'₃ erroné qui a la forme d'un trou ou d'une tranchée en excédent dans la couche sacrificielle 820. La lithographie pour former l'élément correctif C₅ peut être réalisée grâce, à un faisceau de particules ou optique, provenant du même appareil de lithographie que celui utilisé lors de la première étape de lithographie pour former l'élément correctif C₄. A l'aide de ce faisceau, on expose certaines parties de la couche de résine 950.

Après exposition par le faisceau de la couche de résine 950, on développe cette dernière. Les parties non exposées au faisceau 310 de la couche de résine 950 disparaissent. L'élément correctif C₄ sous forme d'un bloc de résine comblant le motif M'₂ est ainsi réalisé.

Puis, on effectue une gravure de la couche technologique 820 à travers la couche de résine 950, gravure au cours de laquelle on ne transfère que les motifs M₅ et M₆.

Quelque soit le mode de réalisation décrit ci-dessus, les étapes de photolithographie peuvent être réalisées à l'aide d'un dispositif de lithographie mis en oeuvre par pilotage d'une machine ou d'un appareil de lithographie 550 à l'aide de données dites « de correction » ou d'au moins un fichier informatique « de correction » permettant la correction souhaitée. Ces données de correction ou ce fichier de correction peuvent être générées par un dispositif de traitement informatique 500, tel que par exemple un ordinateur ou une station de travail.

Un exemple d'opérations logiques, réalisées par un processeur, par exemple, un microprocesseur, ou un processeur d'unité centrale du dispositif 500 permettant de réaliser de telles données ou un tel fichier va être présenté ci-dessous.

Il s'agit en fait d'établir un fichier informatique standard reproduisant les corrections à effectuer.

Pour obtenir les fichiers permettant les corrections d'addition et de soustraction, le dispositif de traitement informatique 500 peut comporter une section de calcul avec des composants électroniques ou logiciels ou autres permettant d'effectuer tous types d'opérations booléennes et également d'effectuer une mise en forme de données sous format directement utilisable par l'appareil de lithographie 550 permettant de produire le faisceau de gravure.

On part de deux fichiers, A et B, le fichier A correspondant au dessin erroné et le fichier B au dessin corrigé souhaité. Ces fichiers peuvent être stockés dans une mémoire, par exemple un disque dur, ou une mémoire morte ROM, ou un disque optique compact, ou une mémoire vive dynamique DRAM ou tout autre type de mémoire RAM, ou un élément de stockage magnétique ou optique, ou des registres ou d'autres mémoires volatiles et/ou non volatiles du dispositif 500.

Pour ce qui concerne les motifs à ajouter, un algorithme comportant une opération booléenne de soustraction, est effectuée entre les deux fichiers A et B, et a pour résultat de ne conserver, par exemple dans un nouveau fichier C₁, que les motifs ajoutés dans le fichier B et qui n'étaient pas dans le fichier A erroné.

Le nouveau fichier C₁, est transmis par le dispositif informatique 500 à l'appareil de lithographie 550, sous forme exploitable. L'appareil 550 peut alors produire un ou plusieurs faisceau(x) de gravure et permet ainsi d'ajouter directement sur une couche mince reposant sur une plaquette, de manière sélective, un ou des motifs manquants.

Pour ce qui concerne les motifs en excédent, à retirer, l'opération booléenne de soustraction peut permettre cette fois ci de ne conserver que les motifs présents uniquement dans le fichier A et que l'on souhaite faire disparaître au final. Après ce traitement, une opération d'ajustement peut être effectuée afin de grandir les bords et d'assurer le recouvrement total du motif à faire disparaître lors du traitement technologique : on s'affranchit ainsi des problèmes de désalignement potentiels induits par le procédé. La taille de l'ajustement dépend de l'environnement des autres motifs dans le dessin final et des performances d'alignement du procédé lithographique utilisé. Un nouveau fichier C₂, résultat de ce traitement, est transmis par le dispositif informatique 500 à l'appareil de lithographie 550, sous forme exploitable.

Lorsque les motifs sont à ajouter et que d'autres motifs sont à supprimer, deux bases ou fichiers de données peuvent être préparées, discrétisant les deux opérations logiques pour obtenir une réparation globale.

Le dispositif informatique 550, va pouvoir mémoriser les données de correction établies de la manière indiquée ci-dessus, et piloter les moyens ou la machine de gravure 500 pour effectuer ces corrections.

### Documents cités

[1] : B. Ward et al., Proc. SPIE, vol. 537, 110-6, 1985.
[2] : US 4,751,169
[3] : EP 0 200 333.

## Revendications

1. Procédé de correction d'un dessin erroné réalisé dans une première couche mince comprenant au moins une première sous-couche (120, 620, 820), la première sous-couche étant une couche sacrificielle gravée comportant ledit dessin erroné obtenu par photolithographie à partir d'un masque comportant des motifs manquants ou en excédent, et au moins une deuxième sous-couche (110, 610, 810) située entre un substrat (100, 600, 800) et la première sous-couche, le procédé comportant les étapes de :
a) dépôt d'une seconde couche mince (300, 700, 900) sur ladite première couche mince,
b) lithographie à écriture directe de ladite seconde couche mince, en fonction de la correction ou des corrections souhaitée(s), puis :
- gravure de la première sous-couche (120) à travers la seconde couche mince (300), puis
- retrait de la seconde couche mince (300), puis,
c) gravure de la deuxième sous-couche (110, 610, 810) à travers la première sous-couche (120, 620, 820), puis
- retrait de la première sous-couche (120, 620, 820).

2. Procédé de correction selon la revendications 1, la correction consistant à un ajout d'un ou plusieurs motifs manquants (M₆) puis à une suppression d'un ou plusieurs autres motifs en excédent (M'₃), le procédé comprenant en outre, après le retrait de la seconde couche mince (900) et préalablement à l'étape c), des étapes de :
- dépôt d'une troisième couche mince (950) sur la première sous-couche (820),
- seconde lithographie dans ladite troisième couche mince (950) laissant des blocs comblant (C₄) lesdits motifs en excédent.

3. Procédé selon la revendication 2, la troisième couche mince (950) étant une couche diélectrique.

4. Procédé selon la revendication 2, la troisième couche mince (950) étant une couche de résine ou de polymère.

5. Procédé selon l'une des revendications 2 à 4, la troisième couche mince (950) étant une couche de résine photosensible.

6. Procédé selon l'une des revendications 2 à 4, comprenant le retrait de la troisième couche mince (950) après l'étape c).

7. Procédé selon l'une des revendications 1 à 6, dans lequel la première sous-couche (120, 620, 820) est à base d'un premier matériau conducteur, ou semi-conducteur, ou isolant et la deuxième sous-couche (110, 610, 810) située entre le substrat (100, 600, 800) et la première sous-couche est à base d'un second matériau conducteur, ou semi-conducteur ou isolant différent du premier matériau.

8. Procédé selon l'une des revendications 1 à 7, la seconde couche mince (300, 700, 900) étant une couche diélectrique.

9. Procédé selon l'une des revendications 1 à 7, la seconde couche mince (300, 700, 900) étant une couche de résine ou polymère.

10. Procédé selon l'une des revendications 1 à 8, la lithographie ou les lithographies étant réalisées à l'aide d'un ou de plusieurs faisceau(x) de particules) ou optique(s).

11. Procédé selon la revendication 10, le faisceau ou les faisceaux étant choisi(s) parmi les faisceaux suivants : faisceau d'ions, faisceau d'électrons, faisceau de protons, faisceau de rayons X, faisceau laser, faisceau de rayons UV.

12. Procédé selon l'une des revendications 10 ou 11, le faisceau étant piloté à l'aide d'un dispositif numérique doté d'un support de données comportant des données relatives au dessin erroné et à un dessin corrigé souhaité.

13. Procédé selon l'une des revendications 1 à 12, dans lequel la lithographie à écriture directe est réalisée à l'aide d'un dispositif comprenant :
- des premiers moyens, apte(s) à produire au moins un faisceau de lithographie,
- des deuxièmes moyens pour traiter des données relatives à un dessin erroné formé dans une couche mince, et des données relatives à un dessin corrigé souhaité, et pour produire suite à ce traitement, des données de correction,
- des troisièmes moyens pour piloter les premiers moyens, à partir de données de correction produites par les seconds moyens.

## Patentansprüche

1. Verfahren zur Korrektur eines in einer ersten Dünnschicht ausgeführten fehlerhaften Motivs, enthaltend zumindest eine erste Unterschicht (120, 620, 820), wobei die erste Unterschicht eine geätzte Opferschicht ist, die das fehlerhafte Motiv aufweist, das durch Photolithographie ausgehend von einer Maske mit fehlenden oder überschüssigen Motivstellen erhalten worden ist, und zumindest eine zweite Unterschicht (110, 610, 810), die zwischen einem Substrat (100, 600, 800) und der ersten Unterschicht liegt, wobei das Verfahren die folgenden Schritte umfasst:
a) Aufbringen einer zweiten Dünnschicht (300, 700, 900) auf die erste Dünnschicht,
b) Lithographie mit direktem Beschreiben der zweiten Dünnschicht in Abhängigkeit von der bzw. den gewünschten Korrektur(en), dann:
- Ätzen der ersten Unterschicht (120) durch die zweite Dünnschicht (300) hindurch, dann
- Entfernen der zweiten Dünnschicht (300), dann
c) Ätzen der zweiten Unterschicht (110, 610, 810) durch die erste Unterschicht (120, 620, 820) hindurch, dann
- Entfernen der ersten Unterschicht (120, 620, 820).

2. Korrekturverfahren nach Anspruch 1, wobei die Korrektur darin besteht, eine oder mehrere fehlende Motivstellen (M₆) hinzuzufügen, dann eine oder mehrere weitere überschüssige Motivstellen (M'₃) zu entfernen,
wobei das Verfahren ferner nach dem Entfernen der zweiten Dünnschicht (900) und vor dem Schritt c) folgende Schritte umfasst:
- Aufbringen einer dritten Dünnschicht (950) auf die erste Unterschicht (820),
- zweite Lithographie in der dritten Dünnschicht (950), wobei Überbrückungsblöcke (C₄) belassen werden, welche die überschüssigen Motivstellen überbrücken.

3. Verfahren nach Anspruch 2, wobei die dritte Dünnschicht (950) eine dielektrische Schicht ist.

4. Verfahren nach Anspruch 2, wobei die dritte Dünnschicht (950) eine Harz- oder Polymerschicht ist.

5. Verfahren nach einem der Ansprüche 2 bis 4, wobei die dritte Dünnschicht (950) eine lichtempfindliche Harzschicht ist.

6. Verfahren nach einem der Ansprüche 2 bis 4, umfassend das Entfernen der dritten Dünnschicht (950) nach Schritt c).

7. Verfahren nach einem der Ansprüche 1 bis 6, wobei die erste Unterschicht (120, 620, 820) auf Basis eines ersten Leitermaterials bzw. Halbleitermaterials bzw. Isoliermaterials ausgeführt ist und die zwischen dem Substrat (100, 600, 800) und der ersten Unterschicht liegende zweite Unterschicht (110, 610, 810) auf Basis eines zweiten Leitermaterials bzw. Halbleitermaterials bzw. Isoliermaterials ausgeführt ist, das sich vom ersten Material unterscheidet.

8. Verfahren nach einem der Ansprüche 1 bis 7, wobei die zweite Dünnschicht (300, 700, 900) eine dielektrische Schicht ist.

9. Verfahren nach einem der Ansprüche 1 bis 7, wobei die zweite Dünnschicht (300, 700, 900) eine Harz- bzw. Polymerschicht ist.

10. Verfahren nach einem der Ansprüche 1 bis 8, wobei die Lithographie bzw. die Lithographien mit Hilfe von einem oder mehreren Partikelstrahlen bzw. optischen Strahlen erfolgen.

11. Verfahren nach Anspruch 10, wobei der bzw. die Strahlen ausgewählt sind aus folgenden Strahlen: lonenstrahlen, Elektronenstrahlen, Protonenstrahlen, Röntgenstrahlen, Laserstrahlen, UV-Strahlen.

12. Verfahren nach einem der Ansprüche 10 oder 11, wobei der Strahl mit Hilfe einer digitalen Vorrichtung gesteuert wird, die mit einem Datenträger ausgestattet ist, der auf das fehlerhafte Motiv oder auf ein gewünschtes korrigiertes Motiv bezogene Daten enthält.

13. Verfahren nach einem der Ansprüche 1 bis 12, wobei die Lithographie mit direktem Beschreiben mit Hilfe einer Vorrichtung erfolgt, die enthält:
- erste Mittel, die dazu geeignet sind, zumindest einen Lithographiestrahl zu erzeugen,
- zweite Mittel zum Verarbeiten von auf ein in einer Dünnschicht ausgebildetes fehlerhaftes Motiv bezogenen Daten und von auf ein gewünschtes, korrigiertes Motiv bezogenen Daten und zum Erzeugen von Korrekturdaten auf diese Verarbeitung folgend,
- dritte Mittel zum Steuern der ersten Mittel ausgehend von den zweiten Mitteln erzeugten Korrekturdaten.

## Claims

1. Method for correction of an erroneous design made in a first thin layer comprising at least one first sub-layer (120, 620, 820), the first sub-layer being engraved and comprising said erroneous design made by photolithography carried out with a mask having missing patterns or patterns in excess, and at least one second sub-layer (110, 610, 810) located between a substrate (100, 600, 800) and the first sub-layer, the method comprising the steps of:
a) depositing a second thin layer (300, 700, 900) on said first thin layer,
b) direct writing lithography of said second thin layer, as a function of the desired correction or corrections, then:
- etching of the first sub-layer (120) through the second thin layer (300),
- removing of the second thin layer (300), then
c) etching of the second sub-layer (110, 610, 810) through the first sub-layer (120, 620, 820), then
- etching of the first sub-layer (120, 620, 820).

2. Correction method as claimed in claim 1, the correction consisting of adding one or more missing patterns (M₆) then eliminating one or more other patterns in excess (M'₃), the method further comprising, after removing of the second thin layer (900) and prior to step c), the steps of:
- depositing a third thin layer (950) on the first sub-layer (820),
- second lithography in said third thin layer (950) leaving blocks filling (C₄) said patterns in excess.

3. Method as claimed in claim 2, the third thin layer (950) being a dielectric layer.

4. Method as claimed in claim 2, the third thin layer (950) being a resin or polymer layer.

5. Method as claimed in any one of claims 2 to 4, the third thin layer (950) being a positive or negative photosensitive resin layer.

6. Method as claimed in any one of claims 2 to 4, comprising removing of the third thin layer (950) after step c).

7. Method as claimed in any one of claims 1 to 6, in which the first sub-layer (120, 620, 820) is based on a first conductive, or semi-conductive, or insulating material and the second sub-layer (110, 610, 810) located between the substrate (100, 600, 800) and the first sub-layer is based on a second conductive, or semiconductive, or insulating material different from the first material.

8. Method as claimed in any one of Claims 1 to 7, the second thin layer (300, 700, 900) being a dielectric layer.

9. Method as claimed in any one of claims 1 to 7, the second thin layer (300, 700, 900) being a resin or polymer layer.

10. Method as claimed in any one of claims 1 to 8, the lithography step or the lithography steps being carried out by means of one or more optical particle beams.

11. Method as claimed in claim 10, the beam or the beams being selected from among the following beams: ion beam, electron beam, proton beam, X-ray beam, laser beam, UV beam.

12. Method as claimed in claim 10 or 11, the beam being controlled by means of a digital device associated with a data medium comprising data relative to the erroneous design and to a desired corrected design.

13. Method as claimed in claims 1 to 12, wherein the direct writing lithography is conducted with a device comprising:
- first means, suitable for producing at least one lithography beam,
- second means for processing data relative to an erroneous design formed in a thin layer, and data relative to a desired corrected design, and for producing correction data following such processing, ,
- third means for controlling the first means, from correction data produced by the second means.
